(19) **Europäisches Patentamt European Patent Office Office européen des brevets**

(11) **EP 4 645 089 A2**

(12) **EUROPEAN PATENT APPLICATION**

(43) Date of publication:
05.11.2025 Bulletin 2025/45

(21) Application number: 25160330.4

(22) Date of filing: 26.02.2025

(51) International Patent Classification (IPC):
*G06F 11/10* (2006.01)

(52) Cooperative Patent Classification (CPC):
G06F 11/1048

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 11.04.2024 CN 202410440461

(71) Applicant: Yangtze Memory Technologies Co.,
Ltd.
Wuhan, Hubei 430000 (CN)

(72) Inventor: LIU, Weilin
Wuhan, Hubei, 430000 (CN)

(74) Representative: Lippert Stachow Patentanwälte
Rechtsanwälte
Partnerschaft mbB
Frankenforster Strasse 135-137
51427 Bergisch Gladbach (DE)

(54) **STORING DATA IN MEMORY SYSTEMS**

(57) The present disclosure involves methods, apparatuses, and systems for storing data in a memory system. In one example, a method of operating a memory system includes: receiving a first write command to write first user data in the memory device, generating, based on a first encoding algorithm, first parity data corresponding to the first user data, storing the first user data and the first parity data in a memory block of a memory device of the memory system, receiving a second write command to write second user data in the memory device, generating, based on a second encoding algorithm, second parity data corresponding to the second user data, the second encoding algorithm being different from the first encoding algorithm, and storing the second user data and the second parity data in the same memory block as the first user data and the first parity data.

EP 4 645 089 A2

FIG. 9

## Description

## TECHNICAL FIELD

The present disclosure generally relates to memory devices and systems for storing data.

## BACKGROUND

A memory system can include one or more memory devices and a memory controller that manages the data stored in the one or more memory devices and communicates with a host. The memory system can be a non-volatile memory (e.g., NAND flash memory) that stores data in memory pages and erase data in memory blocks comprising multiple memory pages. In some cases, errors in the stored data can lead to read failures and affect the reliability of the memory system. The memory system can detect and correct errors in the stored data by using error correction codes (ECC).

## SUMMARY

The present disclosure relates to storing data in a memory system. In one example, a method of operating a memory system includes receiving a first write command to write first user data in the memory device. The method further includes generating, based on a first encoding algorithm, first parity data corresponding to the first user data. The method further includes storing the first user data and the first parity data in a memory block of a memory device of the memory system. The method further includes receiving a second write command to write second user data in the memory device. The method further includes generating, based on a second encoding algorithm, second parity data corresponding to the second user data. The second encoding algorithm is different from the first encoding algorithm. The method further includes storing the second user data and the second parity data in the same memory block as the first user data and the first parity data.

The method can include one or more of the following features.

In some implementations, the second user data and the second parity data are stored in a same memory block as the first user data and the first parity data.

In some implementations, the first parity data and the second parity data include low-density-parity-check (LDPC) parity data. The first encoding algorithm includes a first LDPC matrix, and the second encoding algorithm includes a second LDPC matrix.

In some implementations, the method further includes storing a first identifier of the first user data in a memory controller of the memory system, and storing a second identifier of the second user data in the memory controller. The first identifier corresponds to the first encoding algorithm. The second identifier corresponds to the second encoding algorithm.

In some implementations, the first identifier and the second identifier are stored in a physical-to-logical (P2L) mapping table.

In some implementations, logical addresses of the first user data are mapped to the first identifier in the P2L mapping table, and logical addresses of the second user data are mapped to the second identifier in the P2L mapping table.

In some implementations, the method further includes identifying the first LDPC matrix based on the first identifier, and decoding the first parity data based on the first LDPC matrix.

In some implementations, the first user data are included in logical blocks in a first format, and the second user data are included in logical blocks in a second format.

Certain aspects of the subject matter described here can be implemented as a memory system. The memory system can include one or more memory devices and a memory controller coupled to the one or more memory devices. The memory system is configured to perform operations including receiving a first write command to write first user data in the one or more memory devices. The operations further include generating, based on a first encoding algorithm, first parity data corresponding to the first user data. The operations further include storing the first user data and the first parity data in a memory block of a memory device of the memory system. The operations further include receiving a second write command to write second user data in the one or more memory devices. The operations further include generating, based on a second encoding algorithm, second parity data corresponding to the second user data. The second encoding algorithm is different from the first encoding algorithm. The operations further include storing the second user data and the second parity data in the same memory block as the first user data and the first parity data.

The memory system can include one or more of the following features.

In some implementations, the second user data and the second parity data are stored in a same memory block as the first user data and the second parity data.

In some implementations, the first parity data and the second parity data include low-density-parity-check (LDPC) parity data. The first encoding algorithm includes a first LDPC matrix, and the second encoding algorithm includes a second LDPC matrix.

In some implementations, the operations further include storing a first identifier of the first user data in a memory controller of the memory system, and storing a second identifier of the second user data in the memory controller. The first identifier corresponds to the first encoding algorithm. The second identifier corresponds to the second encoding algorithm.

In some implementations, the first identifier and the second identifier are stored in a physical-to-logical (P2L) mapping table. Logical addresses of the first user data are mapped to the first identifier in the P2L mapping table, and logical addresses of the second user data are mapped to the second identifier in the P2L mapping table.

In some implementations, the first user data are included in logical blocks in a first format, and the second user data are included in logical blocks in a second format.

Certain aspects of the subject matter described here can be implemented as a memory controller. The memory controller can include a first interface, a second interface, and an encoder. The first interface can be configured to receive a first write command that includes first user data, and receive a second write command that includes second user data. The encoder can be configured to generate first parity data corresponding to the first user data based on a first encoding algorithm, and generate second parity data corresponding to the second user data based on a second encoding algorithm. The second encoding algorithm is different from the first encoding algorithm. The second interface can be configured to send a third write command to write the first user data and the first parity data in a memory block of the memory device, and send a fourth write command to write the second user data and the second parity data in the memory block.

The memory system can include one or more of the following features.

In some implementations, the memory controller is configured to control the memory device to store the second user data and the second parity data in a same memory block as the first user data and the first parity data.

In some implementations, the memory controller can further include a decoder. The second interface can be further configured to receive the first user data and the first parity data from the memory block, and receive the second user data and the second parity data from the memory block. The decoder can be configured to decode the first parity data based on the first encoding algorithm, and decode the second parity data based on the second encoding algorithm.

In some implementations, the memory controller is further configured to store a first identifier of the first user data in the memory controller, and store a second identifier of the second user data in the memory controller. The first identifier corresponds to the first encoding algorithm, and the second identifier corresponds to the second encoding algorithm.

In some implementations the first identifier and the second identifier are stored in a physical-to-logical (P2L) mapping table. Logical addresses of the first user data are mapped to the first identifier in the P2L mapping table, and logical addresses of the second user data are mapped to the second identifier in the P2L mapping table.

In some implementations, the first parity data and the second parity data include low-density-parity-check (LDPC) parity data. The first encoding algorithm includes a first LDPC matrix, and the second encoding algorithm includes a second LDPC matrix.

While generally described as computer-implemented software embodied on tangible media that processes and transforms the respective data, some or all of the aspects can be computer-implemented methods or further included in respective systems or other devices for performing this described functionality. The details of these and other aspects and implementations of the present disclosure are set forth in the accompanying drawings and the description below. Other features, objects, and advantages of the disclosure will be apparent from the description and drawings, and from the claims.

**BRIEF DESCRIPTION OF DRAWINGS**

FIG. 1 illustrates a block diagram of an example system having a memory device, according to some aspects of the present disclosure.

FIGS. 2A-2B illustrate example storage products, according to some aspects of the present disclosure.

FIG. 3 illustrates an example of a schematic diagram of a memory device including peripheral circuits, according to some aspects of the present disclosure.

FIG. 4 illustrates some example peripheral circuits, according to some aspects of the present disclosure.

FIG. 5A illustrates a block diagram of an example system including a memory device, a memory controller, and a host, according to some aspects of the present disclosure.

FIG. 5B illustrates a block diagram of an example system including a memory device, a memory controller, and a host, according to some aspects of the present disclosure.

FIG. 6A illustrates an example data structure of a LBA format, according to some aspects of the present disclosure.

FIG. 6B illustrates another example data structure of a LBA format, according to some aspects of the present disclosure.

FIG. 7 illustrates an example physical-to-logical (P2L) mapping table, according to some aspects of the present disclosure.

FIG. 8 illustrates an example data structure of a write command, according to some aspects of the present disclosure.

FIG. 9 illustrates an example method of writing data in a memory system, according to some aspects of the present disclosure.

FIG. 10 illustrates an example method of reading data from a memory system, according to some aspects of the present disclosure.

FIG. 11 illustrates a flowchart of an example method of storing data in a memory system, in accordance with some aspects of the present disclosure.

Like reference numbers and designations in the various drawings indicate like elements.

## DETAILED DESCRIPTION

Error correction is performed in memory systems to ensure data integrity and system reliability. Various factors, such as physical imperfections in memory cells, electrical noise, thermal fluctuations, and natural aging of the memory system, can introduce errors to data stored in the memory system. These errors, specifically erroneous bits in the data, can potentially lead to read failure or data loss. The memory system can utilize error correction codes (ECC) to detect and rectify errors, thereby preserving the accuracy of the data. For example, the memory system can process data using low density parity check (LDPC) codes for error correction. When receiving user data from a host, the memory system can encode the user data by generating parity data using a LDPC matrix. The user data and the corresponding parity data are both stored in a memory device of the memory system. In a read operation, the memory system can retrieve the user data and the corresponding parity data from the memory device. The memory system can further detect and correct erroneous bits in the data by using the LDPC matrix.

In some implementations, the memory system can be configured to receive user data with different logical block addressing (LBA) formats. For example, a memory space of the memory system can be logically divided into more than one namespace. Each namespace can have a corresponding LBA format. That is, logical blocks in different namespaces can be in different formats. The memory system may use different encoding algorithms (e.g., different LDPC matrices) to encode user data with different LBA formats.

In some implementations, a memory block in the memory device stores user data with the same LBA format and their corresponding parity data. In response to receiving user data with different LBA format from the previous user data, a different memory block may be used to store the user data and its corresponding parity data. As such, the memory system may include an excessive number of open memory blocks (i.e., memory blocks that are partially filled with data and still have space to store additional data), which can increase the demand for hold-up capacitors that maintain data in a memory controller of the memory system in an event of power failure. Excessive number of open memory blocks can also increase the demand for redundant array of independent disks (RAID) resources, resulting in escalated hardware costs for the memory system.

In some implementations, a memory block in the memory device can store user data with different LBA formats and their corresponding parity data. In response to receiving user data with a different LBA format from the previous user data, the memory device can store the user data and its corresponding parity data in the same memory block as the previous user data, without opening a separate memory block. The memory system can record an identifier that indicates the encoding algorithm for encoding the user data with each LBA format. As such, by optimizing the allocation of open memory blocks in the memory device, the operations of the memory system can be more cost-effective and power-efficient.

The above aspects and some other aspects of the present disclosure are discussed in greater detail below.

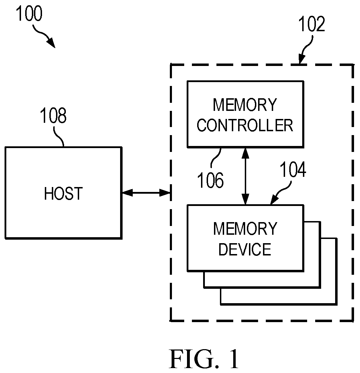

FIG. 1 illustrates a block diagram of an example system 100 having a memory device, according to some aspects of the present disclosure. The system 100 can be a mobile phone, a desktop computer, a laptop computer, a tablet, a vehicle computer, a gaming console, a printer, a positioning device, a wearable electronic device, a smart sensor, a virtual reality (VR) device, an argument reality (AR) device, or any other suitable electronic devices having storage therein. As shown in FIG. 1, the system 100 can include a host 108 and a memory system 102 having one or more memory devices 104 and a memory controller 106. The host 108 can include one or more processors of an electronic device. The processor can be a central processing unit (CPU), or a system-on-chip (SoC), such as an application processor (AP). The host 108 can be configured to send or receive data and commands to or from the memory systems 102.

The memory device 104 can be any memory device disclosed in the present disclosure, such as a NAND Flash memory device. It is noted that the NAND Flash is only one example of memory device for illustrative purposes. It can include any suitable solid-state, non-volatile memory, e.g., NOR Flash, Ferroelectric RAM (FeRAM), Phase-change memory (PCM), Magneto-resistive random- access memory (MRAM), Spin-transfer torque magnetic random-access memory (STT-RAM), or Resistive random-access memory (RRAM), etc. In some implementations, memory device 104 includes a three-dimensional (3D) NAND Flash memory device.

The memory controller 106 can be implemented by microprocessors, microcontrollers (a.k.a. microcontroller units (MCUs)), digital signal processors (DSPs), application-specific integrated circuits (ASICs), field-programmable gate arrays (FPGAs), programmable logic devices (PLDs), state machines, gated logic, discrete hardware circuits, and other suitable hardware, firmware, and/or software configured to perform the various functions described below in detail.

The memory controller 106 is coupled to the memory device 104 and to the host 108, and is configured to control the memory device 104, according to some implementations. The memory controller 106 can manage the data stored in the memory device 104 and can communicate with the host 108. In some implementations, the memory controller 106 is designed for operating in a low duty-cycle environment, such as secure digital (SD) cards, compact Flash (CF) cards, universal serial bus (USB) Flash drives, or other media for use in electronic devices, such as personal computers, digital cameras, mobile phones, etc. In some implementations, memory controller 106 is designed for operating in a high duty-cycle environment solid state drives (SSDs) or embedded multi-media-cards (eMMCs) used as data storage for mobile devices, such as smartphones, tablets, laptop computers, etc., and enterprise storage arrays. The memory controller 106 can be configured to control operations of the memory device 104, such as read, erase, and program operations. The memory controller 106 can also be configured to manage various functions with respect to the data stored or to be stored in the memory device 104 including, but not limited to bad-block management, garbage collection, logical-to-physical address conversion, logical-to-physical mapping management, wear leveling, etc. In some implementations, the memory controller 106 is further configured to process error correction codes (ECCs) with respect to the data read from or written to the memory device 104. Any other suitable functions can be performed by the memory controller 106 as well, for example, formatting the memory device 104.

The memory controller 106 can communicate with an external device (e.g., the host 108) according to a particular communication protocol. For example, the memory controller 106 can communicate with the external device through at least one of various interface protocols, such as a USB protocol, an MMC protocol, a peripheral component interconnection (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a Firewire protocol, etc. The memory controller 106 is configured to receive and transmit a command to and from the host 108, and execute or perform multiple functions and operations provided in the present disclosure, which will be described later.

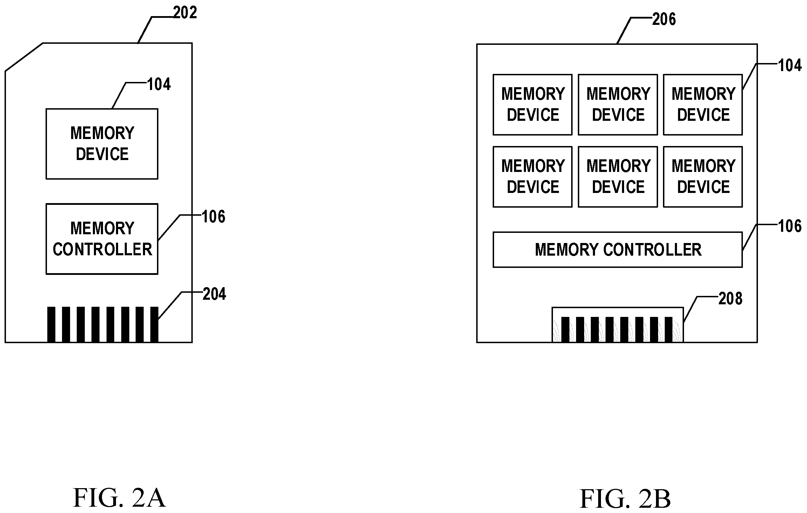

The memory controller 106 and the one or more memory devices 104 can be integrated into various types of storage devices. For example, the memory controller 106 and the one or more memory devices 104 can be packaged in a universal Flash storage (UFS) package or an eMMC package. In one example as shown in FIG. 2A, the memory controller 106 and a single memory device 104 can be integrated into a memory card 202. The memory card 202 can include a PC card (PCMCIA, personal computer memory card international association), a CF card, a smart media (SM) card, a memory stick, a multimedia card (MMC, RS-MMC, MMCmicro), an SD card (SD, miniSD, microSD, SDHC), a UFS, etc. The memory card 202 can further include a memory card connector 204 coupling the memory card 202 with a host (e.g., host 108 in FIG. 1). In another example as shown in FIG. 2B, the memory controller 106 and multiple memory devices 104 can be integrated into an SSD 206. The SSD 206 can further include an SSD connector 208 that couples the SSD 206 with a host (e.g., host 108 in FIG. 1). In some implementations, the storage capacity and/or the operation speed of the SSD 206 is greater than those of the memory card 202.

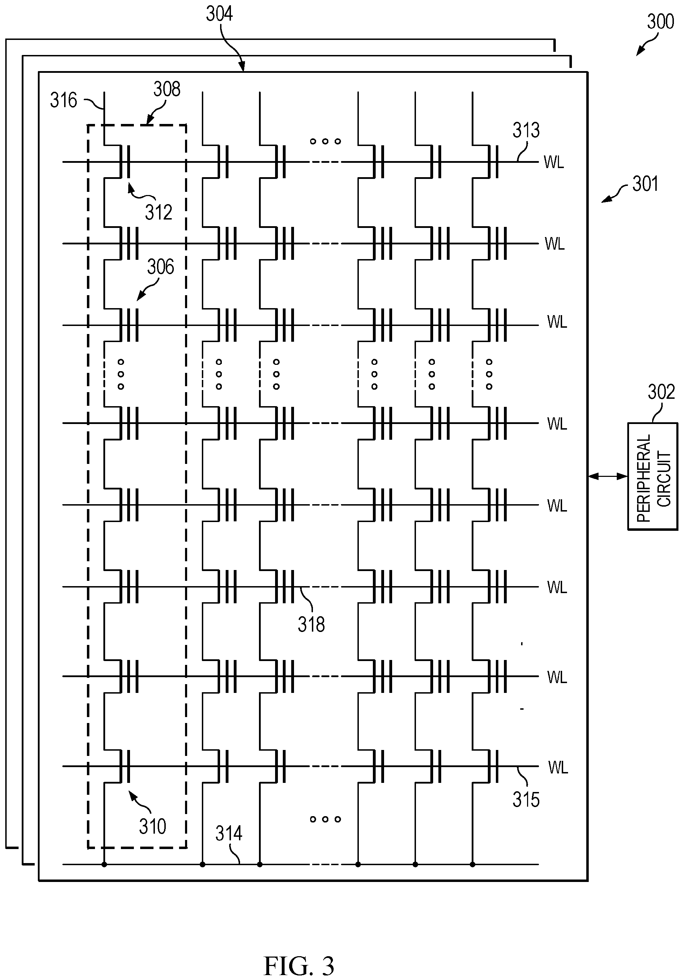

FIG. 3 illustrates an example of a schematic diagram of a memory device 300 including peripheral circuits, according to some aspects of the present disclosure. The memory device 300 can include a memory cell array 301 and peripheral circuits 302 coupled to the memory cell array 301. The memory cell array 301 can be a NAND Flash memory cell array in which memory cells 306 are provided in the form of an array of NAND memory strings 308 each extending vertically above a substrate (not shown in FIG. 3). In some implementations, each NAND memory string 308 includes a plurality of memory cells 306 coupled in series and stacked vertically. Each memory cell 306 can hold a continuous, analog value, such as an electrical voltage or charge that depends on the number of electrons trapped within a storage layer of the memory cell 306. The logic state (i.e., data) of each memory cell 306 in a memory block 304 can be determined based on the threshold voltage $V_{th}$ of the memory cell 306. Each memory cell 306 can be a floating gate type memory cell including a floating-gate transistor, or a charge trap type memory cell including a charge-trap transistor.

In some implementations, each memory cell 306 is a single-level cell (SLC) with two possible memory states that can store one bit of data. For example, the first memory state "0" can correspond to a first range of voltages, and the second memory state "1" can correspond to a second range of voltages. In some implementations, each memory cell 306 is a multi-level cell (MLC) that is capable of storing more than one bit of data in more than two memory states. For example, the MLC can store two bits per cell, three bits per cell (also known as triple-level cell (TLC)), or four bits per cell (also known as a quad-level cell (QLC)). Each MLC can be programmed to support a range of possible nominal storage values. In one example, if each MLC stores two bits of data, then the MLC can be programmed to one of three possible programming levels from an erased state by writing one of three possible nominal storage values to the cell. A fourth nominal storage value can be used for the erased state.

As shown in FIG. 3, each NAND memory string 308 can include a source select gate (SSG) 310 at its source end and a drain select gate (DSG) 312 at its drain end. The SSG 310 and the DSG 312 can be configured to activate selected NAND memory strings 308 (columns of the array) during read and program operations. In some implementations, the sources of NAND memory strings 308 in the same memory block 304 are coupled through a same source line (SL) 314, e.g., a common SL. In other words, NAND memory strings 308 in the same memory block 304 have an array common source (ACS), according to some implementations. The DSG 312 of each NAND memory string 308 is coupled to a respective bit line 316 from which data can be read or written via an output bus (not shown), according to some implementations. In some implementations, each NAND memory string 308 is configured to be selected or deselected by applying a select voltage (e.g., above the threshold voltage of the transistor having the DSG 312) or a deselect voltage (e.g., 0 V) to the respective DSG 312 through one or more DSG lines 313, and/or by applying a select voltage (e.g., above the threshold voltage of the transistor having the SSG 310) or a deselect voltage (e.g., 0 V) to the respective SSG 310 through one or more SSG lines 315.

As shown in FIG. 3, NAND memory strings 308 can be organized into multiple memory blocks 304, each of which can have a common SL 314 coupled to the ACS. In some implementations, each memory block 304 can serve as a basic data unit for erase operations, such that memory cells 306 on the same memory block 304 are erased at the same time. To erase memory cells 306 in a selected memory block 304, the SL 314 coupled to the selected memory block 304 and unselected memory blocks in the same plane can be biased with an erase voltage. For example, the erase voltage can be a high positive voltage (e.g., 20 V or more). In some implementations, an erase operation can be performed at a half-block level, a quarter-block level, or a level having any suitable number of memory blocks or fractions of a memory block.

The memory cells 306 of adjacent NAND memory strings 308 can be coupled through word lines 318. The word line 318 can select which row of memory cells 306 is affected by read and program operations. Each word line 318 can include a gate line coupled to a plurality of control gates (gate electrodes) of a plurality of memory cells 306. Example word lines shown in FIG. 3 are between one or more DSG lines 313 and one or more SSG lines 315.

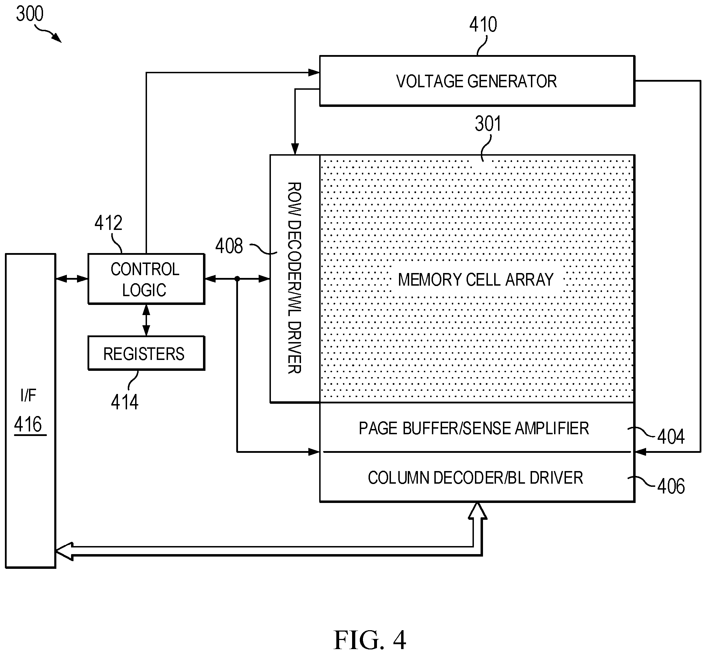

FIG. 4 illustrates some example peripheral circuits 302, according to some aspects of the present disclosure. The peripheral circuits 302 can be coupled to the memory cell array 301 through bit lines 316, word lines 318, SLs 314, SSG lines 315, and DSG lines 313. The peripheral circuits 302 can include any suitable analog, digital, and mixed-signal circuits for facilitating the operations of the memory cell array 301 by applying and sensing voltage signals and/or current signals to and from each target memory cell 306 through bit lines 316, word lines 318, SLs 314, SSG lines 315, and DSG lines 313. The peripheral circuits 302 can include various types of peripheral circuits formed using metal-oxide-semiconductor (MOS) technologies. The example peripheral circuits 302 include a page buffer/sense amplifier 404, a column decoder/bit line driver 406, a row decoder/word line driver 408, a voltage generator 410, control logic 412, registers 414, an interface 416, and a data bus. In some examples, additional peripheral circuits not shown in FIG. 4 may be included as well.

The page buffer/sense amplifier 404 can be configured to read and program (write) data from and to memory cell array 301 according to the control signals from control logic 412. In an example, the page buffer/sense amplifier 404 may store one page of program data (write data) to be programmed into one page 320 of the memory cell array 301. In another example, the page buffer/sense amplifier 404 may perform program verify operations to ensure that the data have been properly programmed into memory cells 306 coupled to selected word lines 418. In still another example, the page buffer/sense amplifier 404 may also sense the low power signals from the bit line 316 that represents a data bit stored in memory cell 306, and amplify the small voltage swing to recognizable logic levels in a read operation. The column decoder/bit line driver 406 can be configured to be controlled by the control logic 412 and select one or more NAND memory strings 308 by applying bit line voltages generated from the voltage generator 410.

The row decoder/word line driver 408 can be configured to be controlled by the control logic 412 and select/deselect memory blocks 304 of the memory cell array 301 and select/deselect word lines 418 of the memory block 304. The row decoder/word line driver 408 can be further configured to drive word lines 418 using word line voltages generated from the voltage generator 410. In some implementations, the row decoder/word line driver 408 can also select/deselect and drive SSG lines 415 and DSG lines 413. As described below in detail, the row decoder/word line driver 408 is configured to apply a program voltage to selected word line 418 in a program operation on memory cell 306 coupled to selected word line 418.

The voltage generator 410 can be configured to be controlled by the control logic 412 and generate the word line voltages (e.g., read voltage, program voltage, pass voltage, local voltage, verify voltage, etc.), bit line voltages, and source line voltages to be supplied to the memory cell array 301.

The control logic 412 can be coupled to each peripheral circuit described above and configured to control operations of each peripheral circuit. The registers 414 can be coupled to the control logic 412 and include status registers, command registers, and address registers for storing status information, command operation codes (OP codes), and command addresses for controlling the operations of each peripheral circuit.

The interface 416 can be coupled to the control logic 412 and act as a control buffer to buffer and relay control commands received from a host (not shown) to the control logic 412 and status information received from the control logic 412 to the host. The interface 416 can also be coupled to the column decoder/bit line driver 406 via a data bus, and act as a data input/output (I/O) interface and a data buffer to buffer and relay data to and from the memory cell array 301.

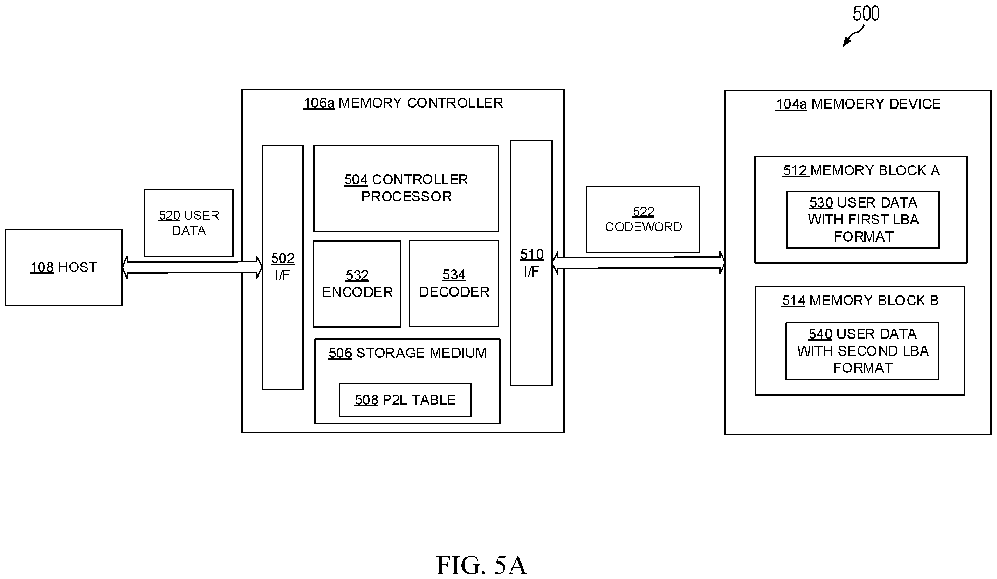

FIG. 5A illustrates a block diagram of an example system 500 including a memory device 104a, a memory controller 106a, and a host 108, according to some aspects of the present disclosure. In some implementations, the memory device 104a is a NAND Flash memory device. The host 108 can send user data 520 (a.k.a., host data) to be stored in the memory device 104a. The host 108 can be configured to send commands (e.g., a write (program) command, a read command, and an erase command) to the memory controller 106a, so that the memory device 104a can perform corresponding operations under the control of the memory controller 106a.

As shown in FIG. 5A, the memory controller 106a can include a controller processor 504, such as a memory chip controller (MCC) or a memory controller unit (MCU). The controller processor 504 is configured to control modules to execute commands or instructions to perform functions disclosed in the present disclosure. The controller processor 504 can also be configured to control the operations of the memory device 104a by generating and sending various control signals, such as program instructions for program operations, and read instructions for read operations. In some implementations, the memory controller 106a can include one or more controller processors. The one or more processors can include a main processor and one or more secondary processors.

The memory controller 106a can further include a storage medium 506. The storage medium 506 can be a volatile memory or a non-volatile memory. In some implementations, the memory controller 106a can include a volatile controller and a non-volatile memory. The storage medium 506 in the form of a volatile memory can include a register or cache memory to allow faster access and process speed to read, program, or erase the data stored therein, while the stored information may not be retained when power is off. In some implementations, the storage medium 506 includes either dynamic random-access memory (DRAM) or static random-access memory (SRAM). The storage medium 506 in the form of a non-volatile memory can retain the stored information when power is off. In some implementations, the storage medium 506 may not be provided in the memory controller 106a. For example, the storage medium 506 is coupled to and deposed outside of the memory controller 106a.

In some implementations, the memory controller 106a can include a first interface 502 configured to receive and transmit commands or instructions from and to the host 108. In some implementations, the first interface 502 is coupled to the controller processor 504 and is configured to receive and transmit commands or instructions that cause the controller processor 504 to perform functions disclosed in the present disclosure. Additionally, the memory controller 106a can include a second interface 510 configured to receive and transmit data or commands to and from the memory device 104a. In some implementations, the second interface 510 is coupled to the controller processor 504 and is configured to transmit commands from the controller processor 504 to the memory device 104a.

In some implementations, the memory controller 106a can include an encoder 532 that includes one or more encoding circuits. When the first interface 502 receives the user data 520 to be stored in the memory device 104a, the encoder 532 can encode the user data 520 by generating parity data of the user data 520. The parity data can be used for error correction when programming and reading data from the memory device 104a. In some cases, when the user data 520 are stored in the memory device 104a, due to electronic drift, data retention problems, or other phenomena, some bits in the user data 520 may flip (e.g., to "0") from what it was original set to (e.g., "1"). These erroneous bits can cause read errors and thus affect the reliability of the memory device 104a. The parity data can be used to detect and correct the erroneous bits, so that the data read from the memory device 104a are accurate and reliable.

In some implementations, the generated parity data are appended to the user data 520 to form a codeword 522. For example, the codeword 522 can include a user data portion that includes the user data 520 received from the host, and a parity data portion following the user data portion that includes the generated parity data. The second interface 510 can send the codeword 522 to the memory device 104a for storage.

In some implementations, the encoder 532 can generate the parity data based on error correcting codes (ECC) such as LDPC codes. The LDPC codes are a class of linear block error-correcting codes with sparse parity-check matrices, enabling efficient error detection and correction for high-density memory devices such as NAND memory devices. The LDPC codes are based on a set of parity-check equations that the transmitted or stored data must satisfy. During a read operation, a decoder 534 can employ iterative algorithms to identify and correct errors by analyzing the discrepancies in the parity-check equations. Specifically, the encoder 532 can generate parity data of the user data 520 based on a LDPC matrix representing the set of parity-check equations. The LDPC matrix can be a sparse binary matrix, predominantly filled with zeros and only a small fraction of ones. In some implementations, a row in the LDPC matrix represents a parity-check equation, and a column in the LDPC matrix corresponds to a bit in the codeword 522. The presence of a "1" in a particular row and column indicates that the corresponding bit of the codeword 522 is included in the associated parity-check equation. In a read operation, the decoder 534 can use the LDPC matrix to identify erroneous bits through an iterative process of checks and balances. By iteratively adjusting the values of bits that violate parity-check constraints, the decoder 534 can converge towards the correct data, thereby correcting errors introduced during the program or read operations.

In some implementations, the memory controller 106a can receive user data 520 with different LBA formats. For example, the system 500 can support different namespaces, which allows for logical separation of different data. This can enable different users or applications to store their data separately on the same physical memory device without interfering with each other. Different namespaces may support different LBA formats. In some implementations, a minimum operable data size (e.g., a size of a logical block, for example 512 bytes, 4K bytes, etc.) can be different when writing or reading data with different LBA formats. In some cases, metadata (e.g., addresses and identifiers) associated with each logical block may vary depending on the LBA format.

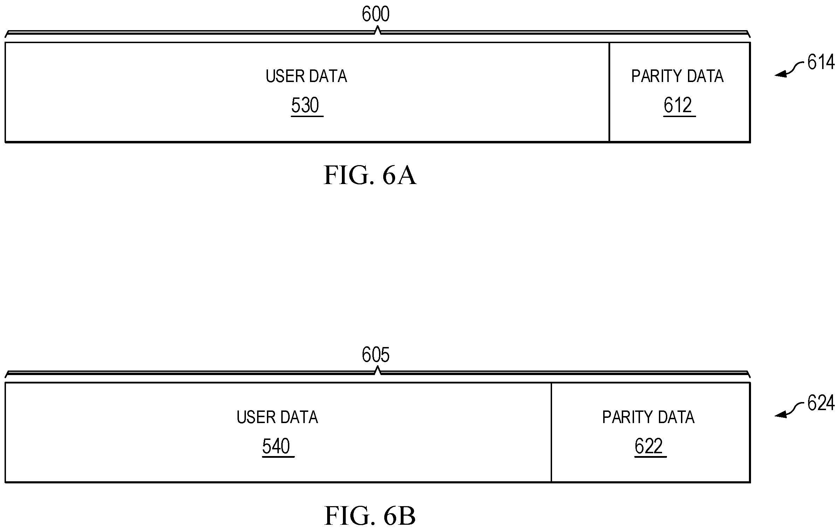

For example, the system 500 can support multiple namespaces including a first namespace and a second namespace. User data 530 in the first namespace can be with a first LBA format, and user data 540 in the second namespace can be with a second LBA format. In some implementations, the encoder 532 can use different encoding algorithms (i.e., different LDPC matrices, given that the memory system adopts LDPC codes as ECC codes) to generate parity data corresponding to user data 530, 540 with different LBA formats. As shown in FIGs. 6A and 6B, user data 530 can be with the first LBA format, and user data 540 can be with the second LBA format. In some cases, user data 530 and 540 can have different sizes, due to the differences in the minimum operable data size indicated by different LBA formats. When user data 530 and 540 are stored in the memory device 104a, they are stored in allocation units 600, 605 of a fixed size. The allocation unit can be a page, half of a page, quarter of a page, or a stripe in a RAID structure. For example, each allocation unit in the memory device has a fixed size of 4K bytes. As shown in FIGs. 6A and 6B, user data 530 occupies a portion of the allocation unit 600, and the remaining space in the allocation unit 600 can be used for storing parity data 612 that correspond to user data 530. The encoder 532 can use LDPC matrix 01 to generate the parity data 612. User data 530 and corresponding parity data 612 can be included in codeword 614. In comparison, user data 540 may occupy a smaller portion of the allocation unit 605, and the allocation unit 605 may have a larger remaining space to store parity data 622 that correspond to user data 540. The encoder 532 can use a different LDPC matrix, e.g., LDPC matrix 02, to generate the parity data 622. As such, the allocation unit 605 can have a higher encoding rate (i.e., a ratio of parity data bits/user data bits) than the allocation unit 600, and therefore can have a higher error correction capacity. User data 540 and corresponding parity data 622 can be included in codeword 624. In some implementations, parity data 612 and parity data 622 may have the same length, but can be different in other aspects such as data structure (e.g., whether it contains regular LDPC codes or irregular LDPC codes), parity-check density (e.g., density of parity-check matrix needed to decode the parity data), etc.

Referring back to FIG. 5A, in some implementations, the encoder 532 can generate the parity data based on other ECC codes such as Reed-Solomon codes, other Bose-Chaudhuri-Hocquenghem (BCH) codes, and Hamming codes. For example, a typical BCH code applied to a 512-byte (4096-bit) sector of data can correct at most four erroneous bits, if at least 60 bits are used for parity data. Reed-Solomon codes are a subset of BCH codes and are also commonly used for error correction. For example, a typical Reed-Solomon code can correct at most four erroneous bits in a 512-byte sector of data, if approximately 72 bits are used for parity data.

The memory controller 106a can include a decoder 534 that includes one or more decoding circuits. During a read operation, the decoder can detect and correct errors bits in the data. For example, if LDPC codes are used as the ECC codes, the decoder 534 can employ iterative algorithms to identify and correct errors by analyzing the discrepancies in the parity-check equations represented by the LDPC matrices. In some implementations, a memory block can store codewords 614, 624 that correspond to user data with different LBA formats. For example, the codeword 614 that includes user data 530 and parity data 612 and the codeword 624 that includes user data 540 and parity data 622 are stored in the same memory block of the memory device 104a. The decoder 534 can decode the codeword 614 using its corresponding LDPC matrix (e.g., LDPC matrix 01), and decode the codeword 624 using its corresponding LDPC matrix (e.g., LDPC matrix 02). Further, the decoder 534 can identify the LDPC matrix corresponding to a given codeword based on the identifier recorded by the memory controller 106a when encoding the data.

In some implementations, the decoder 534 can operate based on a LDPC hard decoding strategy and a LDPC soft decoding strategy. The LDPC hard decoding strategy uses the hard value (i.e., 0 or 1) of each received bit. The LDPC soft decoding strategy used both the hard value of each received bit, and a log-likelihood ratio (LRR) representing a likelihood of that bit being 0 or 1. For example, for a given bit, the LRR is calculated as

$$LRR = \ln\left(\frac{P(bit=1)}{P(bit=0)}\right)$$

. In some implementations, when the decoder 534 detects a read error, it can implement multiple mechanisms to correct the error. For example, the first mechanism can use a default read voltage to read the data, and apply the LDPC hard decoding strategy for data decoding. If the first mechanism fails to read the data, a second mechanism can be implemented. The second mechanism can use a set of read voltages in a read-retry table to read the data, and apply the LDPC hard decoding strategy for data decoding. If the second mechanism also fails, a third mechanism can be implemented. The third mechanism can use a set of shifted read voltages to read the data, and apply the LDPC soft decoding strategy for data decoding. If the third mechanism also fails, a fourth mechanism can be implemented to use a RAID data restoration strategy to handle the read error. If the fourth mechanism also fails, a data loss is reported to the host 108.

When the memory controller receives the user data 520 from the host 108, a flash-translation layer (FTL) (not shown in FIG. 5A) of the memory controller 106a can determine a physical address in the memory device 104a to store the data, and can translate the logical address of the user data 520 to the physical address. After the encoder 532 generates the codeword 522 (i.e., appending parity data to the user data 520), the codeword is stored in a memory space indicated by the physical address. Further, the FTL can generate one or more mapping tables that show a mapping relation between logical addresses of the data and physical addresses where the data are stored. In some implementations, the one or more mapping tables can include a logical-to-physical (L2P) mapping table and a physical-to-logical (P2L) mapping table. The L2P mapping table can map logical addresses to physical addresses. When new data are stored in a physical address, the memory controller 106a can update the entry in the L2P mapping table. For example, the memory controller 106a can unmap the physical address from the logical address of replaced data, and associate the physical address to the logical address of the new data. The P2L mapping table can map physical addresses to logical addresses. When new data are stored in a physical address, the memory controller 106a can add a new entry in the P2L mapping table to map the logical address of the new data and the physical address, without deleting or modifying the previous entry that maps the physical address to the logical address of the replaced data.

In some implementations, the L2P mapping table and the P2L mapping table are stored in the storage medium 506 of the memory controller 106a. In some implementations, the memory controller 106a can send the P2L mapping table and a portion of the L2P mapping table (e.g., a second-level table of a multi-level L2P mapping table) to the memory device 104a on a regular basis, so that the mapping tables can be recovered in case of accidental power off.

The second interface 510 can send the codeword 522 (e.g., codeword 614 in FIG. 6A and codeword 624 in FIG. 6B) including user data 520 and its corresponding parity data to the memory device 104a for storage. In some implementations, e.g., as shown in FIG. 5A, since the encoding algorithms to generate codewords 614, 624 for user data 530, 540 with different LBA formats are different, the codewords 614, 624 are stored in different memory blocks (e.g., a memory block 304 in FIG. 3) of the memory device 104a. In other words, data in the first namespace and data in the second namespace are stored in different memory blocks of the memory device. For example, codeword 614 that includes user data 530 with the first LBA format can be stored in memory block A 512 of the memory device, and codeword 624 that includes user data 540 with the second LBA format can be stored in memory block B 514 of the memory device. As such, in one memory block, the parity data in different allocations units are generated based on the same encoding algorithm (i.e., the same LDPC matrix, given that the memory system adopts LDPC codes as ECC codes). However, this may lead to an excessive number of open memory blocks in the memory device 104a.

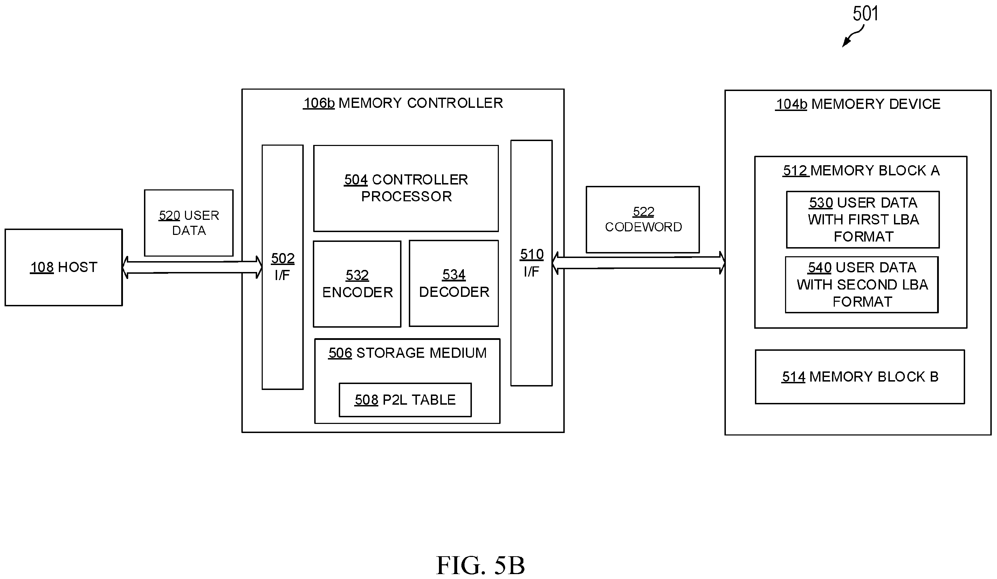

FIG. 5B illustrates a block diagram of an example system 501 including a memory device 104b, a memory controller 106b, and a host 108, according to some aspects of the present disclosure. The memory device 104b and the memory controller 106b can be same as, or similar to the memory device 104a and the memory controller 106a, except that in the system 501, the memory controller 106b can control the memory device 104b to store the codewords 614, 624 that correspond to user data 530, 540 with different LBA formats in the same memory block. In other words, data in the first namespace and data in the second namespace can be stored in the same memory block. For example, as shown in FIG. 5B, user data 530 with the first LBA format, which are included in codeword 614, can be stored in memory block A 512. User data 540, which are included in codeword 624, can also be stored in memory block A 512. Further, the memory controller 106b can record an identifier that indicates the encoding algorithm used to encode each user data 530, 540. As such, the number of open memory blocks in the memory device 104b can be optimized.

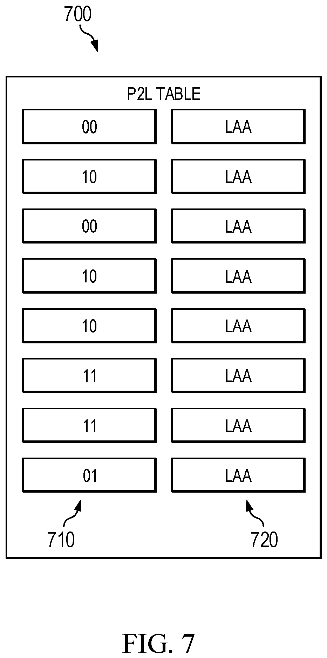

In some implementations, the memory controller 106b can record the identifier that indicates the encoding algorithm implemented to encode each user data in the P2L mapping table. For example, as shown in FIG. 7, a P2L mapping table 700 can have a first column 710 recording the identifiers indicating the encoding algorithms. For example, binary number 00, 01, 10, 11 in the first column 710 can respectively represent four different LDPC matrices that are used to encode data with four different LBA formats. The P2L mapping table 700 can further include a second column 720 that records the logical addresses of the data, and a third column (not shown in FIG. 7) recording the physical addresses where the data are stored. In the P2L mapping table 700 as shown in FIG. 7, the physical addresses can be represented by the row number of each entry. For example, the data associated with the logical address in the first row of the P2L mapping table can be stored in the first allocation unit of the memory block, and the data associated with the logical address in the second row can be stored in the second allocation unit of the memory block. In response to a write command, when mapping the logical address of the data with the physical address where the data are stored, the P2L mapping table 700 can further map the identifier of the LDPC matrix that is implemented by the encoder 532 to encode the data. In other implementations, the memory controller 106b can record the identifier indicating the encoding algorithm in other mapping tables or by other suitable means.

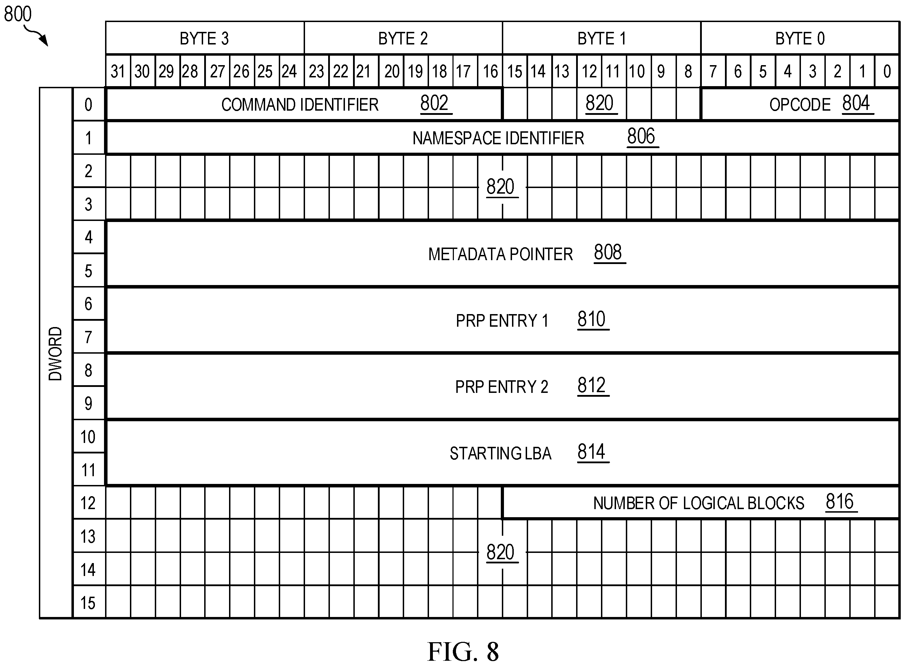

FIG. 8 illustrates an example data structure 800 of a write command, according to some aspects of the present disclosure. The data structure 800 can have 16 bytes divided into 4 DWORDs, where a DWORD has 4 bytes. The data structure 800 contains information that instructs a memory system to perform a write operations. For example, the data structure 800 can include a command identifier 802, which is a command ID to track the progress and response of each command. An operation code (Opcode) 804 can indicate the operation to be performed, e.g., a write command in this case. A namespace identifier 806 can identify the namespace where the data will be stored. In some implementations, the namespace identifier can correspond to an LBA format of the data to be stored.

In addition, the data structure 800 can further the following elements. A meta data pointer 808 can point to the location of the metadata for the write operations. Physical region page (PRP) entry 1 810 can point to the first memory block or first memory page where the data are stored. PRP entry 2 812 can point to a second memory block or a second memory page, if the data are stored across more than one memory block or one memory page. Starting LBA 814 can indicate a start logical address of where to start writing data, while a number of logical addresses 816 can indicate a length of the data. The data structure 800 can further include reserved bits 820 for future use or command-specific use.

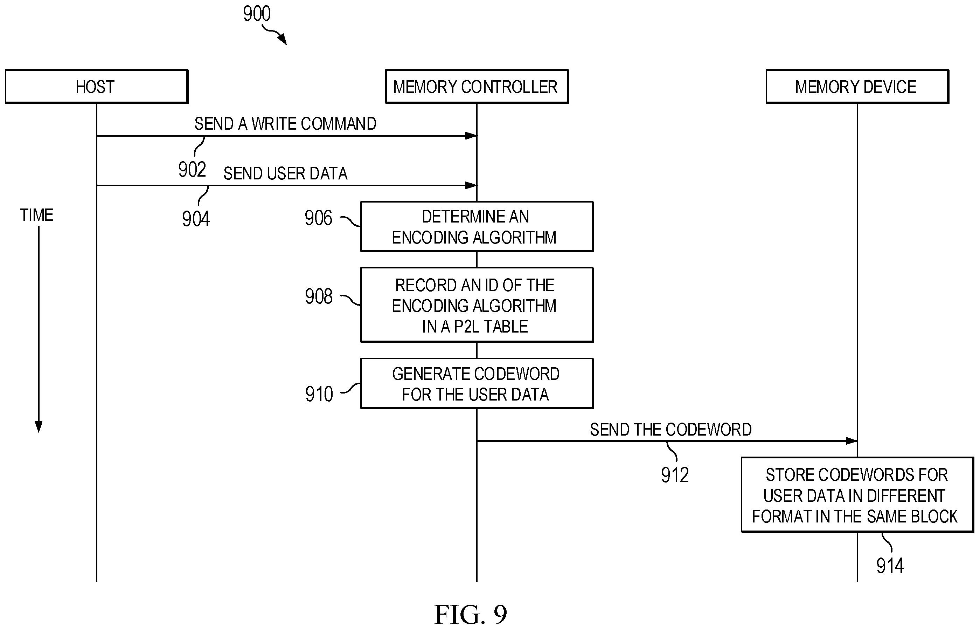

FIG. 9 illustrates an example method 900 of writing data in a memory system, according to some aspects of the present disclosure.

At 902, a host can send a write command (the write command in data structure 800 in FIG. 8) to a memory controller coupled to a memory device. The write command can include a namespace identifier that indicates the namespace where the user data associated with the write command will be stored. In some implementations, the data associated with the write command is with a LBA format corresponding to the namespace.

At 904, the host sends the user data associated with the write command to the memory controller. In some implementations, the host sends the user data after receiving an RTT (ready to transfer) signal from the memory controller.

At 906, the memory controller can determine an encoding algorithm that corresponds to the LBA format that the user data are with. For example, if LDPC code is implemented as the parity code for the encoding scheme, the encoding algorithm can be a LDPC matrix that corresponds to the LBA format that the use data are in. In some implementations, the LDPC matrices used to encode user data with different LBA formats are different.

At 908, the memory controller can record an identifier of the encoding algorithm in a P2L mapping table (e.g., the P2L mapping table 700 in FIG. 7). For example, the memory controller can map the identifier of the encoding algorithm (e.g., a binary identifier of a LDPC matrix) to the logical address of the user data, while mapping the logical address of the user data to the physical addresses in the memory device where the user data will be stored. It should be noted that operation 906 can be performed before, after or at the same time as operation 908.

At 910, the memory controller can encode the user data based on the identified encoding algorithm (e.g., an LDPC matrix), thereby generating the codeword (e.g., codeword 614 in FIG. 6A, 624 in FIG. 6B) for the user data. In some implementations, an encoder (e.g., the encoder 532 in FIG. 5A or FIG. 5B) can generate the codeword that can include a user data portion and a parity data portion appended to the end of the user data portion. The parity data portion can include parity data generated based on the user data using the identified LDPC matrix.

At 912, the memory controller sends the generated codeword to the memory device for storage. For example, the codeword can be stored in an allocation unit (e.g., allocation unit 600 in FIG. 6A, 605 in FIG. 6B) in the memory device.

At 914, the memory device stores codewords for user data with different LBA formats in the same memory block. For example, with reference to FIGs. 5 and 6, the codeword 614 that corresponds to user data 530 with the first LBA format and the codeword 624 that corresponds to user data 540 with the second LBA format can be stored in allocation units 600, 605 in the same memory block of the memory device.

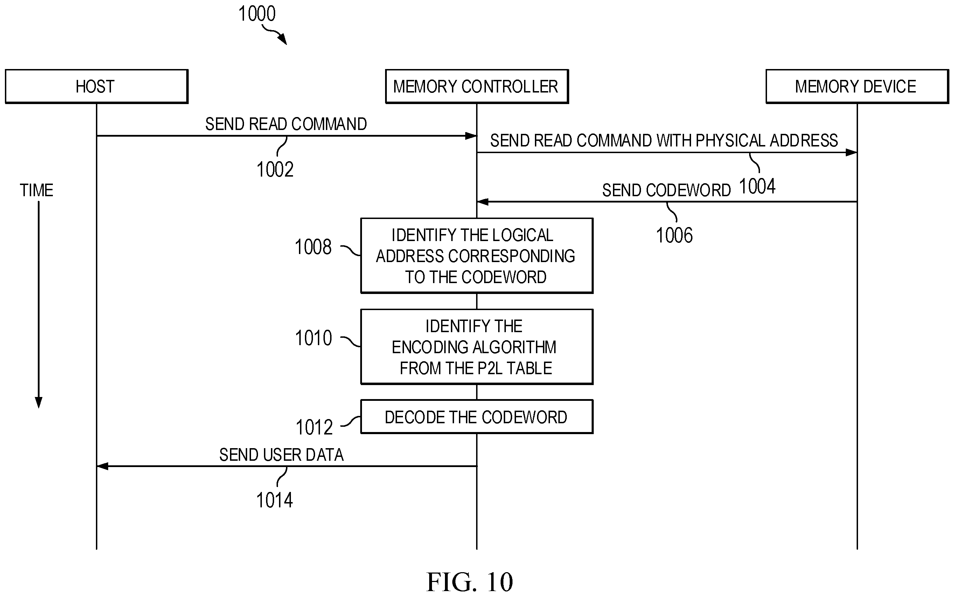

FIG. 10 illustrates an example method 1000 of reading data from a memory system, according to some aspects of the present disclosure.

At 1002, the host sends a read command to the memory controller. The read command can include logical addresses (e.g., a starting LBA and a length of 620LBAs) of the data to be read from the memory device. In response to receiving the read command, the memory controller can identify physical addresses of the data to be read. For example, the memory controller can identify the physical addresses based on the logical addresses using an L2P mapping table.

At 1004, the memory controller sends a read command and the identified physical addresses to the memory device. The read command can instruct the memory device to read data from the identified physical addresses. In some implementations, the codeword that includes the data to be read (i.e., user data) and its corresponding parity data are stored at the identified physical addresses.

At 1006, the memory device sends the codeword that includes the user data and the corresponding parity data to the memory controller. In some implementations, the memory device can send the codeword in response to receiving a read command, or receiving a command to perform garbage collection (GC) operations for purpose of managing and optimizing the storage space in the memory device, or in other scenarios where the memory controller needs to read data from the memory device.

At 1008, the memory controller identifies the logical address corresponding to the codeword. For example, the memory controller can identify the logical address from the read command that includes the logical address of the data to be read. For another example, the memory controller can identify the logical address based on the physical address of the codeword, by checking a mapping table such as a L2P mapping table or a P2L mapping table.

At 1010, the memory controller can identify the encoding algorithm (e.g., the LDPC matrix) based on the identified logical address. The identified encoding algorithm is used in the write operation as shown in method 900 to generate the codeword based on the received user data. For example, the memory controller can identify the LDPC matrix from the P2L mapping table, which records the mapping relationship between logical addresses of data and identifiers of the LDPC matrices implemented to encode the data.

At 1012, the memory controller can decode the codeword based on a decoding algorithm associated with the encoding algorithm. In some implementations, the decoding algorithm can be the same LDPC matrix used to encode the user data. For example, a decoder (e.g., the decoder 534 in FIG. 5A or FIG. 5B) can determine whether the received codeword satisfies the parity-check equations indicated by the LDPC matrix. If the received codeword does not satisfy the parity-check equations, it indicates erroneous bits in the codeword. The decoder can correct the erroneous bits by iteratively flipping bits in the codeword until the parity-check equations are satisfied, or until reaching a minimum number of unsatisfied parity checks. After correcting the erroneous bits, the decoder can converge to the correct user data initially received from the host.

At 1014, the memory controller can send the user data decoded from the codeword to the host. In some implementations, if the read operation is performed in response to GC operations, method 1000 does not include operation 1014, and the user data can be stored in the storage medium of the memory controller before they are re-written to a different memory space in the memory device.

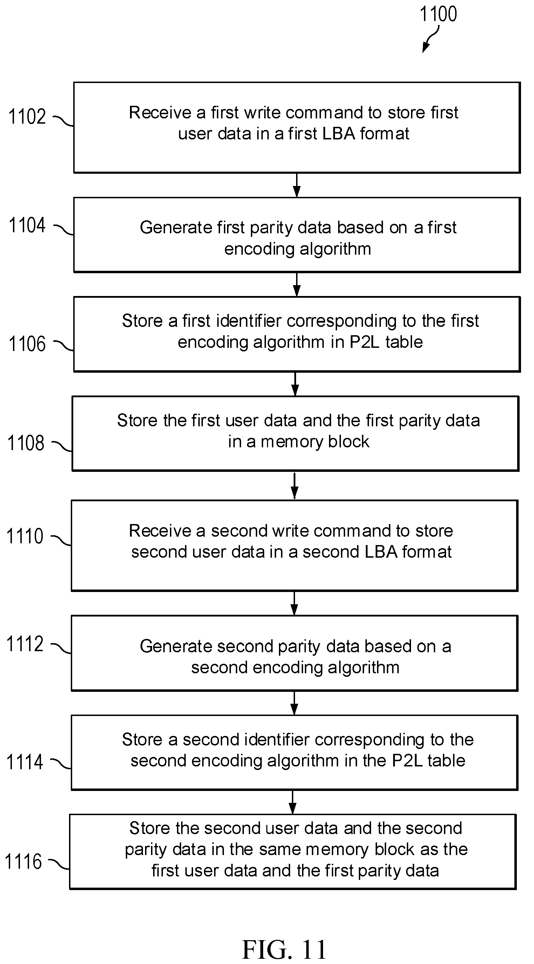

FIG. 11 illustrates a flowchart of an example method 1100 of writing data in a memory system, in accordance with some aspects of the present disclosure.

At 1102, a memory controller coupled to a memory device receives a first write command from a host. The first write command indicates writing first user data (e.g., user data 530 in FIG. 6A) in the memory device. The first user data can be with a first LBA format.

At 1104, the memory controller can generate first parity data (e.g., parity data 612 in FIG. 6A) that correspond to the first user data. The first parity data can be generated based on a first encoding algorithm (e.g., LDPC matrix 01) that corresponds to the LBA format of the first user data. In some implementations, the first parity data can be appended to the end of the first user data to form a first codeword (e.g., the codeword 614 in FIG. 6A).

At 1106, the memory controller can store a first identifier corresponding to the first encoding algorithm in a P2L mapping table (e.g., the P2L mapping table 700 in FIG. 7). The P2L mapping table can map the first identifier to the logical address of the first user data.

At 1108, the memory device can store the first user data and the first parity data (e.g., the first codeword 614 in FIG. 6A) in a memory block (e.g., the memory block 304 in FIG. 3). For example, the first user data and the first parity data can be stored in a first allocation unit (e.g., the allocation unit 605 in FIG. 6B) of the memory block.

At 1110, the memory controller receives a second write command from the host. The second write command indicates writing second user data (e.g., user data 540 in FIG. 6B) in the memory device. The second user data can be with a second LBA format.

At 1112, the memory controller can generate second parity data (e.g., parity data 622 in FIG. 6B) that correspond to the second user data. The second parity data can be generated based on a second encoding algorithm (e.g., LDPC matrix 02) that corresponds to the LBA format of the second user data. In some implementations, the second parity data can be appended to the end of the second user data to form a second codeword (e.g., the codeword 624 in FIG. 6B).

At 1114, the memory controller can store a second identifier corresponding to the second encoding algorithm in the P2L mapping table (e.g., the P2L mapping table 700 in FIG. 7). The P2L mapping table can map the second identifier to the logical address of the second user data.

At 1116, the memory device can store the second user data and the second parity data (e.g., the second codeword 624 in FIG. 6B) in the same memory block (e.g., the memory block 304 in FIG. 3) as the first user data and the first parity data. For example, the second user data and the second parity data can be stored in a second allocation unit (e.g., the allocation unit 605 in FIG. 6B) of the memory block 304. When the memory device receives read commands to read the first user data and the second user data, the first user data and the second user data are read from the same memory block of the memory device.

While this specification contains many specific implementation details, these should not be construed as limitations on the scope of what may be claimed, but rather as descriptions of features that may be specific to particular implementations. Certain features that are described in this specification in the context of separate implementations can also be implemented, in combination, in a single implementation. Conversely, various features that are described in the context of a single implementation can also be implemented in multiple implementations, separately, or in any sub-combination. Moreover, although previously described features may be described as acting in certain combinations and even initially claimed as such, one or more features from a claimed combination can, in some cases, be excised from the combination, and the claimed combination may be directed to a sub-combination or variation of a sub-combination.

As used in this disclosure, the terms "a," "an," or "the" are used to include one or more than one unless the context clearly dictates otherwise. The term "or" is used to refer to a nonexclusive "or" unless otherwise indicated. The statement "at least one of A and B" has the same meaning as "A, B, or A and B." In addition, the phraseology or terminology employed in this disclosure, and not otherwise defined, is for the purpose of description only and not of limitation. Any use of section headings is intended to aid reading of the document and is not to be interpreted as limiting; information that is relevant to a section heading may occur within or outside of that particular section.

As used in this disclosure, the term "about" or "approximately" can allow for a degree of variability in a value or range, for example, within 10%, within 5%, or within 1% of a stated value or of a stated limit of a range.

As used in this disclosure, the term "substantially" refers to a majority of, or mostly, as in at least about 50%, 60%, 70%, 80%, 90%, 95%, 96%, 97%, 98%, 99%, 99.5%, 99.9%, 99.99%, or at least about 99.999% or more.

Values expressed in a range format should be interpreted in a flexible manner to include not only the numerical values explicitly recited as the limits of the range, but also the individual numerical values or sub-ranges encompassed within that range as if each numerical value and sub-range is explicitly recited. For example, a range of "0.1% to about 5%" or "0.1% to 5%" should be interpreted to include about 0.1% to about 5%, as well as the individual values (for example, 1%, 2%, 3%, and 4%) and the sub-ranges (for example, 0.1% to 0.5%, 1.1% to 2.2%, 3.3% to 4.4%) within the indicated range. The statement "X to Y" has the same meaning as "about X to about Y," unless indicated otherwise. Likewise, the statement "X, Y, or Z" has the same meaning as "about X, about Y, or about Z," unless indicated otherwise.

Particular implementations of the subject matter have been described. Other implementations, alterations, and permutations of the described implementations are within the scope of the following claims as will be apparent to those skilled in the art. While operations are depicted in the drawings or claims in a particular order, such operations are not required be performed in the particular order shown or in sequential order, or that all illustrated operations be performed (some operations may be considered optional), to achieve desirable results. In certain circumstances, multitasking or parallel processing (or a combination of multitasking and parallel processing) may be advantageous and performed as deemed appropriate.

Moreover, the separation or integration of various system modules and components in the previously described implementations are not required in all implementations, and the described components and systems can generally be integrated together or packaged into multiple products.

Accordingly, the previously described example implementations do not define or constrain the present disclosure. Other changes, substitutions, and alterations are also possible without departing from the spirit and scope of the present disclosure.

The foregoing description of the specific implementations can be readily modified and/or adapted for various applications. Therefore, such adaptations and modifications are intended to be within the meaning and range of equivalents of the disclosed implementations, based on the teaching and guidance presented herein.

The breadth and scope of the present disclosure should not be limited by any of the above-described example implementations, but should be defined only in accordance with the following claims and their equivalents. Accordingly, other implementations also are within the scope of the claims.

**Claims**

1. A method of operating a memory system (102), comprising:

   receiving a first write command to store first user data in a memory device (104) of the memory system (102);
   generating, based on a first encoding algorithm, first parity data corresponding to the first user data;
   storing the first user data and the first parity data in a memory block (304) of the memory device (104);
   receiving a second write command to store second user data in the memory device (104);
   generating, based on a second encoding algorithm, second parity data corresponding to the second user data, wherein the second encoding algorithm is different from the first encoding algorithm; and
   storing the second user data and the second parity data in the memory block (304).

2. The method of claim 1, wherein the second user data and the second parity data are stored in a same memory block (304) as the first user data and the first parity data.

3. The method of claim 1, wherein the first parity data and the second parity data comprise low-density-parity-check (LDPC) parity data, and wherein the first encoding algorithm comprises a first LDPC matrix, and the second encoding algorithm comprises a second LDPC matrix.

4. The method of claim 3, further comprising:

   storing a first identifier of the first user data in a memory controller (106) of the memory system (102), wherein the first identifier corresponds to the first encoding algorithm; and

storing a second identifier of the second user data in the memory controller (106), wherein the second identifier corresponds to the second encoding algorithm.

5. The method of claim 4, wherein the first identifier and the second identifier are stored in a physical-to-logical (P2L) mapping table, and preferably wherein logical addresses of the first user data are mapped to the first identifier in the P2L mapping table (700), and logical addresses of the second user data are mapped to the second identifier in the P2L mapping table (700).

6. The method of claim 4, further comprising:

identifying the first LDPC matrix based on the first identifier; and
decoding the first parity data based on the first LDPC matrix.

7. The method of claim 1, wherein the first user data are comprised in logical blocks in a first format, and the second user data are comprised in logical blocks in a second format.

8. A memory system (102) comprising:

one or more memory devices (104); and
a memory controller (106) coupled to the one or more memory devices (104), wherein the memory system (102) is configured to perform operations comprising:

receiving a first write command to store first user data in the one or more memory devices (104);
generating, based on a first encoding algorithm, first parity data corresponding to the first user data;
storing the first user data and the first parity data in a memory block (304) of the memory device (104);
receiving a second write command to store second user data in the one or more memory devices (104);
generating, based on a second encoding algorithm, second parity data corresponding to the second user data, wherein the second encoding algorithm is different from the first encoding algorithm; and
storing the second user data and the second parity data in the memory block (304).

9. The memory system (102) of claim 8, wherein

a) the second user data and the second parity data are stored in a same memory block (304) as the first user data and the second parity data; and/or
b) the first parity data and the second parity data comprise low-density-parity-check (LDPC) parity data, and wherein the first encoding algorithm comprises a first LDPC matrix, and the second encoding algorithm comprises a second LDPC matrix.

10. The memory system (102) of claim 8, wherein the operations further comprise:

storing a first identifier of the first user data in the memory controller (106), wherein the first identifier corresponds to the first encoding algorithm; and
storing a second identifier of the second user data in the memory controller (106), wherein the second identifier corresponds to the second encoding algorithm, and preferably wherein the first identifier and the second identifier are stored in a physical-to-logical (P2L) mapping table, and wherein logical addresses of the first user data are mapped to the first identifier in the P2L mapping table (700), and logical addresses of the second user data are mapped to the second identifier in the P2L mapping table (700).

11. The memory system (102) of claim 8, wherein the first user data are comprised in logical blocks in a first format, and the second user data are comprised in logical blocks in a second format.

12. A memory controller (106) comprising:

a first interface (502) configured to:

receive a first write command comprising first user data; and
receive a second write command comprising second user data;

an encoder (532) configured to:

generate first parity data corresponding to the first user data based on a first encoding algorithm; and
generate second parity data corresponding to the second user data based on a second encoding algorithm, wherein the second encoding algorithm is different from the first encoding algorithm; and

a second interface (510) configured to:

send a third write command to write the first user data and the first parity data in a memory block (304) of a memory device (104); and

send a fourth write command to write the second user data and the second parity data in the memory block (304).

13. The memory controller (106) of claim 12, wherein

i) the memory controller (106) is configured to control the memory device (104) to store the second user data and the second parity data in a same memory block (304) as the first user data and the first parity data; and/or

ii) the second interface (510) is further configured to receive the first user data and the first parity data from the memory block (304); and to receive the second user data and the second parity data from the memory block (304); and wherein the memory controller (106) further comprises a decoder configured to:

decode the first parity data based on the first encoding algorithm; and decode the second parity data based on the second encoding algorithm.

14. The memory controller (106) of claim 12, further configured to:

store a first identifier of the first user data, wherein the first identifier corresponds to the first encoding algorithm; and

store a second identifier of the second user data, wherein the second identifier corresponds to the second encoding algorithm, and the memory controller (106) preferably wherein the first identifier and the second identifier are stored in a physical-to-logical (P2L) mapping table, and wherein logical addresses of the first user data are mapped to the first identifier in the P2L mapping table (700), and logical addresses of the second user data are mapped to the second identifier in the P2L mapping table (700).

15. The memory controller (106) of claim 12, wherein the first parity data and the second parity data comprise low-density-parity-check (LDPC) parity data, wherein the first encoding algorithm comprises a first LDPC matrix, and the second encoding algorithm comprises a second LDPC matrix.

100

102

MEMORY
CONTROLLER

106

104

MEMORY
DEVICE

108

HOST

FIG. 1

206

104

106

208

| MEMORY DEVICE | MEMORY DEVICE | MEMORY DEVICE |
| MEMORY DEVICE | MEMORY DEVICE | MEMORY DEVICE |

MEMORY CONTROLLER

FIG. 2B

202

104

106

204

MEMORY DEVICE

MEMORY CONTROLLER

FIG. 2A

FIG. 3

FIG. 4

FIG. 5A

500

104a MEMOERY DEVICE

512 MEMORY BLOCK A
530 USER DATA WITH FIRST LBA FORMAT

514 MEMORY BLOCK B
540 USER DATA WITH SECOND LBA FORMAT

522 CODEWORD

106a MEMORY CONTROLLER

510 I/F

504 CONTROLLER PROCESSOR

534 DECODER

532 ENCODER

506 STORAGE MEDIUM

508 P2L TABLE

502 I/F

520 USER DATA

108 HOST

EP 4 645 089 A2

**106b MEMORY CONTROLLER**

**104b MEMOERY DEVICE**

**108 HOST**

**520 USER DATA**

**502 I/F**

**504 CONTROLLER PROCESSOR**

**532 ENCODER**

**534 DECODER**

**506 STORAGE MEDIUM**

**508 P2L TABLE**

**510 I/F**

**522 CODEWORD**

**512 MEMORY BLOCK A**

**530 USER DATA WITH FIRST LBA FORMAT**

**540 USER DATA WITH SECOND LBA FORMAT**

**514 MEMORY BLOCK B**

**501**

FIG. 5B

EP 4 645 089 A2

600

| USER DATA 530 | PARITY DATA 612 |

← 614

## FIG. 6A

605

| USER DATA 540 | PARITY DATA 622 |

← 624

## FIG. 6B

700

## P2L TABLE

| | |
|---|---|
| 00 | LAA |
| 10 | LAA |
| 00 | LAA |
| 10 | LAA |
| 10 | LAA |
| 11 | LAA |
| 11 | LAA |
| 01 | LAA |

710       720

FIG. 7

FIG. 8

FIG. 9

FIG. 10

EP 4 645 089 A2

1100

1102 — Receive a first write command to store first user data in a first LBA format

1104 — Generate first parity data based on a first encoding algorithm

1106 — Store a first identifier corresponding to the first encoding algorithm in P2L table

1108 — Store the first user data and the first parity data in a memory block

1110 — Receive a second write command to store second user data in a second LBA format

1112 — Generate second parity data based on a second encoding algorithm

1114 — Store a second identifier corresponding to the second encoding algorithm in the P2L table

1116 — Store the second user data and the second parity data in the same memory block as the first user data and the first parity data

FIG. 11